# EUROPEAN PATENT APPLICATION

(11) **EP 1 898 461 A2**
(43) Date of publication of application: **12.03.2008**
(21) Application number: 07253499.3
(22) Date of filing: 04.09.2007
(51) Int. Cl.: H01L 21/84, H01L 27/12

(54) **Liquid crystal display panel and method for manufacturing the same**

(30) Priority: 07.09.2006 JP 2006242274
(71) Applicant: Future Vision Inc., Tokyo 107-0052 (JP)
(72) Inventor: Yoshimoto, Yoshikazu, Minato-ku, Tokyo 107-0052 (JP)
(74) Representative: Calderbank, Thomas Roger

(57) **Abstract**

The present invention discloses a method for manufacturing a liquid crystal display panel and said liquid crystal display panel by simplifying the manufacturing process and by manufacturing the liquid crystal display panel at lower cost. The ink jet direct drawing method is introduced in the process or in several processes to manufacture a source electrode SD1 and a drain electrode SD2 including gate lines, gate electrodes and data lines of the liquid crystal display panel, and ink jet direct drawing process is used for the formation of an active layer island, which has a laminated layer comprising a silicon semiconductor layer SI and an n⁺ contact layer NS.

## Description

The present invention relates to a liquid crystal display system. In particular, the invention relates to a method for manufacturing an active matrix type liquid crystal display panel and a liquid crystal display panel manufactured by said method.

### [Description of the Prior Art]

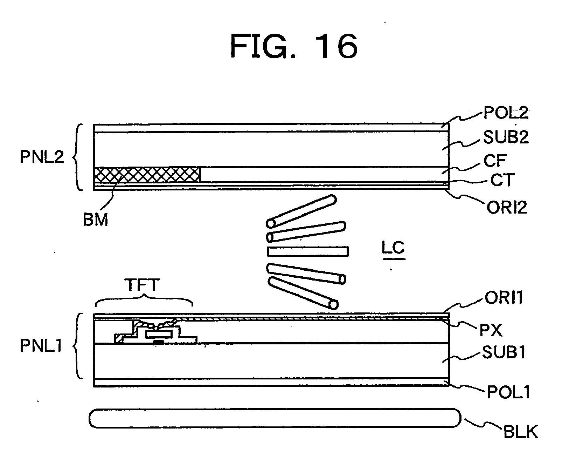

A liquid crystal display system comprises a liquid crystal display panel PNL and a combination of a driving circuit and peripheral devices such as backlight. Fig. 16 is a schematical cross-sectional view to explain an example of approximate arrangement of a typical longitudinal electric field type (the so-called TN type) liquid crystal display system. Normally, a liquid crystal display panel, which constitutes an active matrix type liquid crystal display system, is prepared by sealing a liquid crystal LC between a first panel PNL1 including a first substrate (an active matrix type substrate or a thin-film transistor substrate) and a second panel PNL2 comprising a second substrate (a counter substrate or a color filter substrate).

On inner surface of a first substrate SUB1, which constitutes the first panel PNL1, there are provided a thin-film transistor TFT and a pixel electrode PX driven by the thin-film transistor TFT. On the uppermost layer, a first orientation film ORI1 is deposited, which is provided with an ability to control liquid crystal orientation. On outer surface (back surface), a first polarizing plate POL1 is attached. On the other hand, on inner surface of the second substrate SUB2, which constitutes the second panel PNL2, there are arranged a color filter CF, a light-shielding layer (black matrix) BM to partition off from the color filter of adjacent pixel, and a counter electrode CT are disposed. On the uppermost layer, a second orientation film ORI2 is deposited, which is provided with an ability to control liquid crystal orientation. Also, on outer surface (front surface), a second polarizing plate POL2 is attached with its polarization axis in crossed Nicols arrangement to a polarization axis of the first polarizing plate POL1. Detailed arrangement is not shown in the figure.

In the manufacturing process to prepare the thin-film transistor TFT on the first substrate SUB1, a plurality of gate lines made of films of metal such as chromium and arranged in parallel and gate electrodes extending from the gate lines for each pixel are prepared. Then, an insulator layer, an active layer (silicon semiconductor layer), a data line, a drain electrode and a source electrode, a pixel electrode, a protective film, an orientation film, etc. are prepared. The orientation film is provided with an ability to control liquid crystal orientation, and the first substrate is prepared. On the back surface of the first substrate SUB1, a backlight BLK is mounted. The circuit to drive this liquid crystal display panel is not shown in the figure.

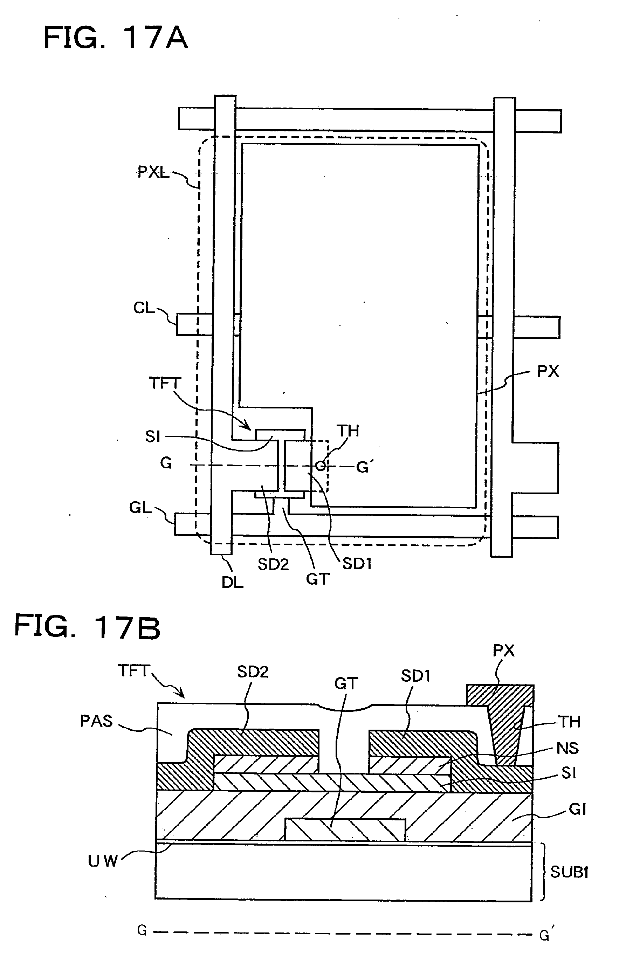

Fig. 17 represents drawings to explain an example of arrangement of a pixel on the liquid crystal display panel as described in connection with Fig. 16 and an example of arrangement of the thin-film transistor, which makes up this pixel. Specifically, Fig. 17 (a) is a plan view of the pixel, and Fig. 17 (b) is a cross-sectional view along the line G-G' in Fig. 17 (a). As shown in Fig. 17 (a), a pixel is formed on a region surrounded by adjacent gate lines and data lines. In this pixel region, the thin-film transistor TFT is disposed at an intersection of the gate line GL and the data line DL. The pixel electrode PX to make up the pixel is connected to a source electrode SD1 of the thin-film transistor TFT via a contact hole TH, and an auxiliary capacity is provided between the auxiliary capacity line CL and the pixel electrode. The source electrode and the drain electrode are switched over to each other during operation. Here, description is given by assuming that the source electrode SD1 and the drain electrode SD2 are not switched over.

In Fig. 17 (b), the thin-film transistor TFT is formed on an underlying film UW prepared on the surface of the first substrate SUB1. A gate insulator film GI is formed to cover the gate electrode GT, which is extending from the gate line GL. On this gate insulator film GI, a silicon (Si) semiconductor layer SI used as an active layer, an ohmic contact layer (n⁺ Si) NS (may be referred simply as "contact layer"), a source electrode SD1 and a drain electrode SD2 are sequentially laminated. The underlying film UW is formed by a laminated film of silicon nitride and silicon oxide.

To cover the gate line GL and the gate electrode GT, a gate insulator film GI preferably made of silicon nitride (SiNx) is deposited, and a plurality of data lines DLs perpendicularly crossing the gate lines GLs are formed on it. At the same time as the formation of the data lines DLs, a source electrode SD1 and a drain electrode SD2 are formed on the same layer.

In case of full-color display, the pixel is a sub-pixel - each in a single color (red, green or blue). Here, it is simply referred as a pixel. As described above, the thin-film transistor TFT to constitute the pixel comprises a gate electrode GT, a silicon semiconductor film SI prepared by patterning on the gate electrode, an ohmic contact layer (n⁺ silicon) NS formed separately on upper layer of the silicon semiconductor film, and a source electrode and a drain electrode connected respectively to the separated ohmic contact layer.

On an upper layer of the thin-film transistor, a protective film PAS is deposited. A pixel electrode PX preferably made of ITO is prepared on it by patterning and is connected to the source electrode SD1 via a contact hole TH formed on the protective film PAS. A first orientation film (see Fig. 16) is deposited to cover the pixel electrode PX and the protective film PAS, but these are not shown in the figure.

On the other hand, in case of full-color display, a 3-color filter and a counter electrode (see Fig. 16) via a smooth layer (overcoating layer; not shown in Fig. 16)are formed on the other substrate not shown in the figure. A second orientation film (see Fig. 16) is deposited to cover the counter electrode. This is superimposed on the active matrix substrate, which is the other substrate as described above, and a liquid crystal is sealed in the gap.

The Patent Document 1 discloses the formation of lines and the like of the thin-film transistor as described above by ink jet method. In the Patent Document 1, it is described that the gate electrode of the thin-film transistor TFT is formed by ink jet method using a liquid containing an electroconductive material, and also that the source electrode and the drain electrode of the thin-film transistor TFT are formed by ink jet method by using a liquid containing a semiconductor material.
[Patent Document 1] JP-A-2003-318193

In the formation of the thin-film transistor on the thin-film transistor substrate, photolithographic method is used in each of the following processes: (1) the formation of gate electrode; (2) the formation of active layer island; (3) the formation of source-drain electrode; (4) the formation of contact hole; and (5) the formation of pixel electrode. The photolithographic method comprises the repeating of the procedures of: metal sputtering process, resist coating and mask exposure and development process, etching process, and removing off and rinsing of resist. However, in the photolithographic method to repeat these procedures, a large-scale facility using light exposure mask is required, and this causes hindrance to the reduction of the manufacturing cost.

In recent years, instead of the processes as described above, an ink jet direct drawing method has been proposed. By adopting the ink jet direct drawing method, the procedure to form the thin-film transistor can be simplified, and the manufacturing facility can be reduced and production efficiency can be extensively improved. Much expectation is now placed on the method, by which the liquid crystal display system would be manufactures at lower cost.

More concretely, it is possible to reduce the number of photolithographic processes by introducing the ink jet direct drawing method in the preparation of the gate lines and the gate electrodes of thin-film transistor and the source-drain electrode including data lines. However, three photolithographic processes are still required.

It is an object of the present invention to provide a liquid crystal display panel and a method for manufacturing the liquid crystal display panel in the process to manufacture the thin-film transistor, to simplify the manufacturing process by reducing the number of photolithographic processes as much as possible by applying the ink jet direct drawing method and to extensively reduce the cost to manufacture the liquid crystal display system.

To attain the above object, according to the present invention, the ink jet direct drawing method is introduced in one or several processes to prepare source-drain electrode including gate lines, gate electrodes and data lines of a liquid crystal display panel and the ink jet direct drawing method is adopted for the formation of an active layer island.

According to the present invention, it is possible to obtain the liquid crystal display panel at lower cost.

### IN THE DRAWINGS:

Fig. 1 is a process chart to explain essential portion of Embodiment 1 of a process for manufacturing a first substrate, which constitutes a liquid crystal display panel according to the present invention;
Fig. 2 is a schematical drawing to explain an essential structure in the process shown in Fig. 1;
Fig. 3 is a schematical drawing to explain an essential structure in the process shown in Fig. 1;
Fig. 4 is a schematical drawing to explain an essential structure in the process shown in Fig. 1;
Fig. 5 is a schematical drawing to explain an essential structure in the process shown in Fig. 1;
Fig. 6 is a schematical drawing to explain an essential structure in the process shown in Fig. 1;
Fig. 7 is a process chart continued from Fig. 1 to explain essential portion of Embodiment 1 of the process for manufacturing a first substrate (thin-film transistor substrate), which constitutes the liquid crystal display panel of the present invention;
Fig. 8 represents schematical drawings to explain essential structure in the process shown in Fig. 7;
Fig. 9 represents schematical drawings to explain essential structure in the process shown in Fig. 7;
Fig. 10 represents schematical drawings to explain essential structure in the process shown in Fig. 7;
Fig. 11 represents schematical drawings to explain essential structure in the process shown in Fig. 7;
Fig. 12 represents schematical drawings to explain essential structure in the process shown in Fig. 7;
Fig. 13 is a process comparison chart to explain the effects of the present invention;
Fig. 14 is another process comparison chart to explain the effects of the present invention;
Fig. 15 represents diagrams to explain equivalent circuit of an active matrix type liquid crystal display system;
Fig. 16 is a schematical drawing to explain an example of approximate arrangement of a pixel in a typical longitudinal electric field type (the so-called TN type) liquid crystal display system; and
Fig. 17 is a schematical drawing to explain an example of arrangement of a pixel in the liquid crystal display panel described in connection with Fig. 16 and an example of approximate arrangement of a thin-film transistor, which constitutes the pixel.

Detailed description will be given below on the preferred embodiment of the invention referring to the attached drawings.

### [Embodiment 1]

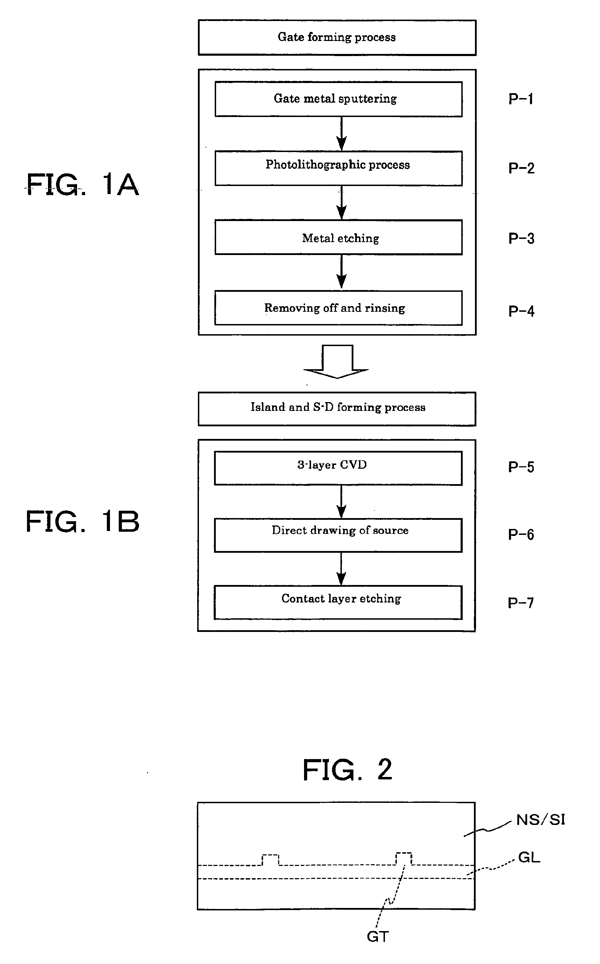

Fig. 1 is a process chart to explain essential portion of Embodiment 1 of a process for manufacturing a first substrate (thin-film transistor substrate), which makes up a liquid crystal display panel of the present invention. It is a process chart to show the processes from the formation of a gate to the formation of an active layer island. The formation of the gate includes the formation of a gate line and a gate electrode. In Embodiment 1, the gate electrode is prepared by photolithographic process, and the active layer island is prepared by patterning process using a source-drain electrode, which is prepared by direct drawing of an electroconductive ink, as an etching mask.

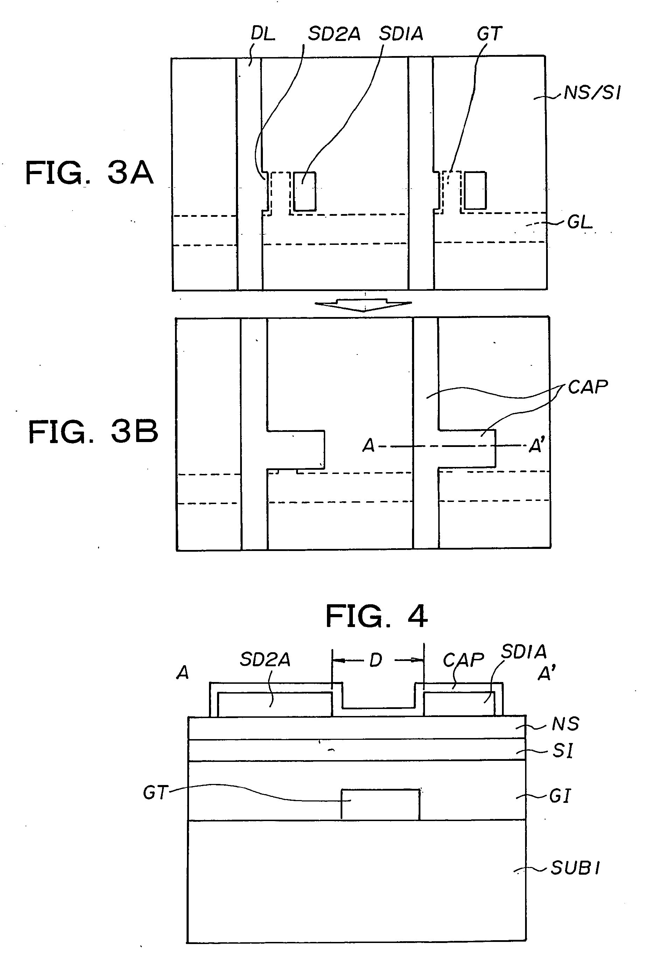

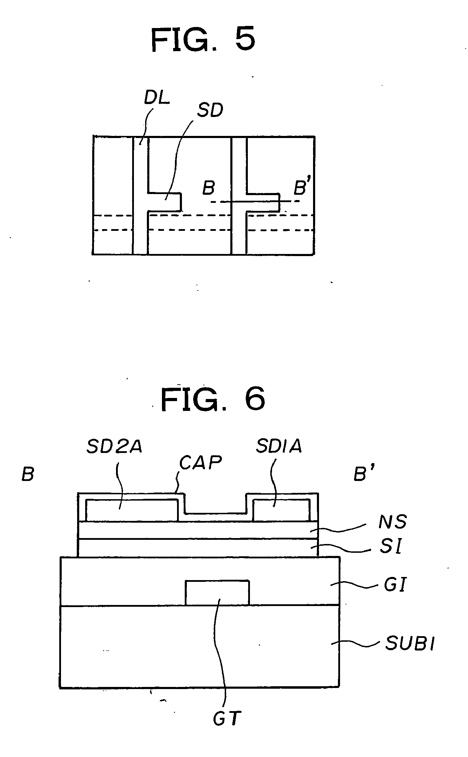

Fig. 2 to Fig. 6 each represents a drawing of an essential structure in the process shown in Fig. 1. Fig. 4 is a cross-sectional view along the line A-A' in Fig. 3, and Fig. 6 is a cross-sectional view along the line B-B' in Fig. 5. In the following, description will be given on the process of Fig. 1 by referring to Fig. 2 to Fig. 6. In the formation of a gate in Fig. 1 (a), a metal for forming the gate (chromium, aluminum, copper, etc.) is sputtered, and a metal thin-film is deposited (P-1). On this metal thin-film, a photosensitive resist is coated, and a gate pattern of resist is formed by light exposure using a light exposure mask and development process (P-2). Etching is performed on the metal exposed from the resist, and only the portion covered by the photosensitive resist is kept untouched (P-3). The photosensitive resist is removed off and rinsed, and a gate (gate line and gate electrode) is prepared (P-4).

In the process for forming the active layer island and the source-drain electrode as shown in Fig. 1 (b), after the formation of the gate, on upper layer of a gate line GL and a gate electrode GT as shown in the plan view of Fig. 2, a gate insulator film GI, a silicon semiconductor layer SI, and an n⁺ silicon layer NS which is to be turned to a contact layer is deposited in this order by CVD method (3-layer CVD method) (P-5). On this upper layer, a source electrode material (source-drain electrode and data line material) and an ink (a first electroconductive ink) are applied by the ink jet direct drawing, and source direct drawing patterns DLA, SD1A and SD2A are prepared (P-6) as shown in Fig.3(a). This is given as source direct drawing process in Fig. 1 (b).

Further, the source direct drawing pattern is turned to a continuous conductive film including a channel region of the thin-film transistor. On it, a transparent conductive film preferably made of ITO is applied by the ink jet direct drawing, and a cap layer CAP is formed (see Fig. 3 (b) and Fig. 4). In this case, the cap layer CAP is also coated on the contact layer NS of the channel region. Using the source-drain electrode and the channel region where the cap layer CAP is formed by the ink jet direct drawing as a mask, etching is performed on the contact layer (n⁺ silicon layer). Next, etching is performed on the silicon semiconductor layer SI, and an active island is formed (P-7) (see Fig. 5 and Fig. 6).

As a first electroconductive ink, low-resistance metal particles such as silver particles or copper particles are dispersed in a solvent and used. As a second electroconductive ink, transparent electroconductive particles or metal particles are dispersed in a solvent and used. As the low-resistance metal particles contained in the first electroconductive ink, silver particles or copper particle or mixture of these particles are preferably used. As the transparent conductive particles in the second electroconductive ink, metal oxide particles such as ITO (indium tin oxide) or IZO (indium zinc oxide) or IZTO are used. As the metal particles, nickel particles may be used.

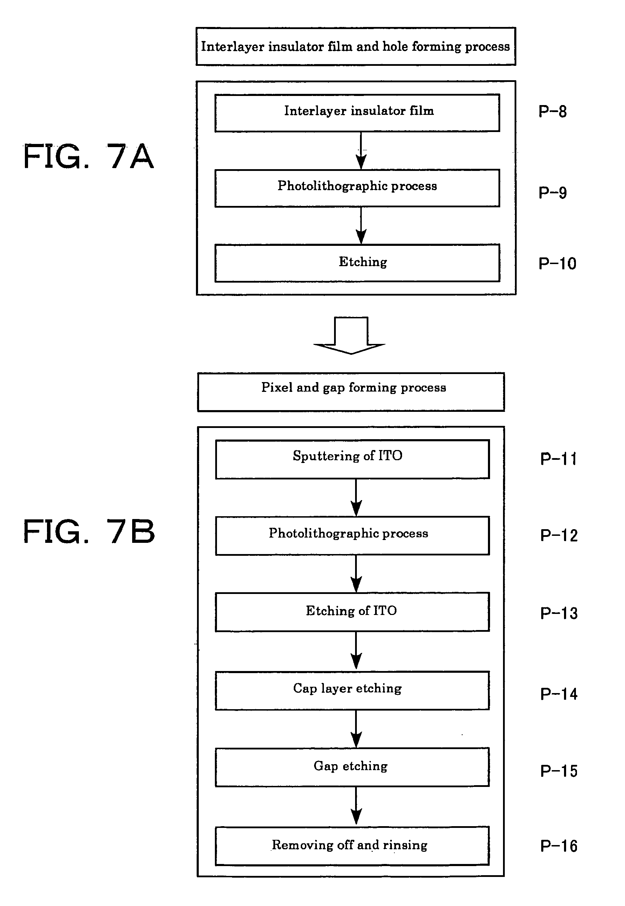

Fig. 7 is a process chart continued from Fig. 1 to explain essential portion of Embodiment 1 in the process for manufacturing the first substrate (thin-film transistor substrate), which constitutes the liquid crystal display panel of the invention. This is a process chart from the formation of an interlayer insulator film and a contact hole to the formation of a gap of pixel electrode and channel.

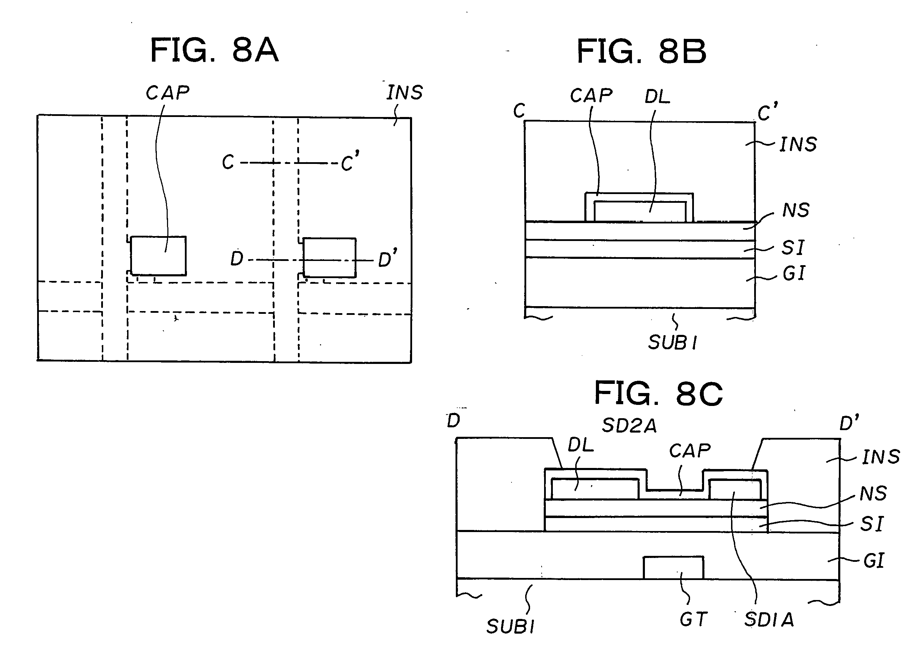

Fig. 8 to Fig. 12 each represents drawings in the process of Fig. 7. Now, referring to Fig. 8 to Fig. 12, description will be given on the process of Fig. 7.

In Fig. 7 (a), an interlayer insulator film is prepared to cover the active layer island, which has been formed by etching using the source-drain electrode with the cap layer CAP on it and the channel region as a mask (P-8). The photosensitive resist is coated on this interlayer insulator film. Light exposure is performed by using a light exposure mask, and the interlayer insulator film on the cap layer of the source-drain electrode of the active layer island is solubilized (P-9). After the development process and the etching of this portion (P-10), the cap layer of the source-drain electrode is exposed (see Fig. 8).

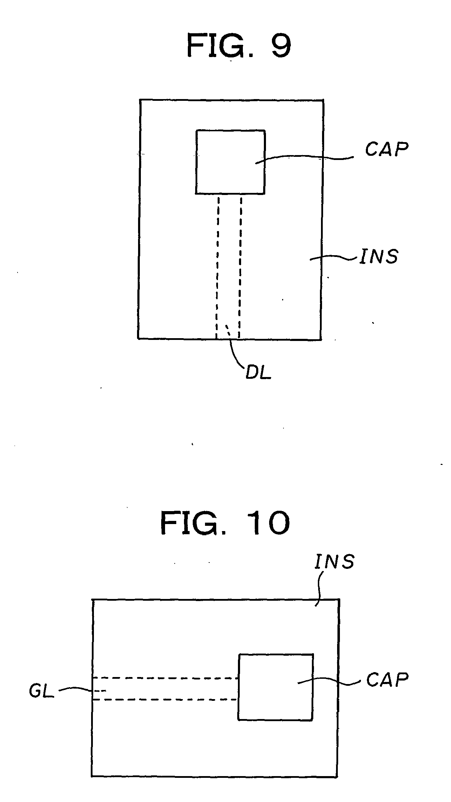

Fig. 8 (a) is a plan view of an essential portion including the source-drain electrode formed by the process (P-10) of Fig. 7. Fig. 8 (b) is a cross-sectional view along the line C-C' of the data line DL shown in Fig. 8 (a). Fig. 8 (c) is a cross-sectional view along the line D-D' of the thin-film transistor shown in Fig. 8 (a). By the process (P-10) of Fig. 7, a cap layer CAP of the source-drain electrode is exposed. The other portion is covered by the interlayer insulator film INS. However, as shown in Fig. 9 and Fig. 10, the terminal region (Fig. 9) of the data line DL and the terminal region (Fig.10) of the gate line GL are also processed by the photolithographic process and by the etching at the same time so that the cap layer CAP will be exposed.

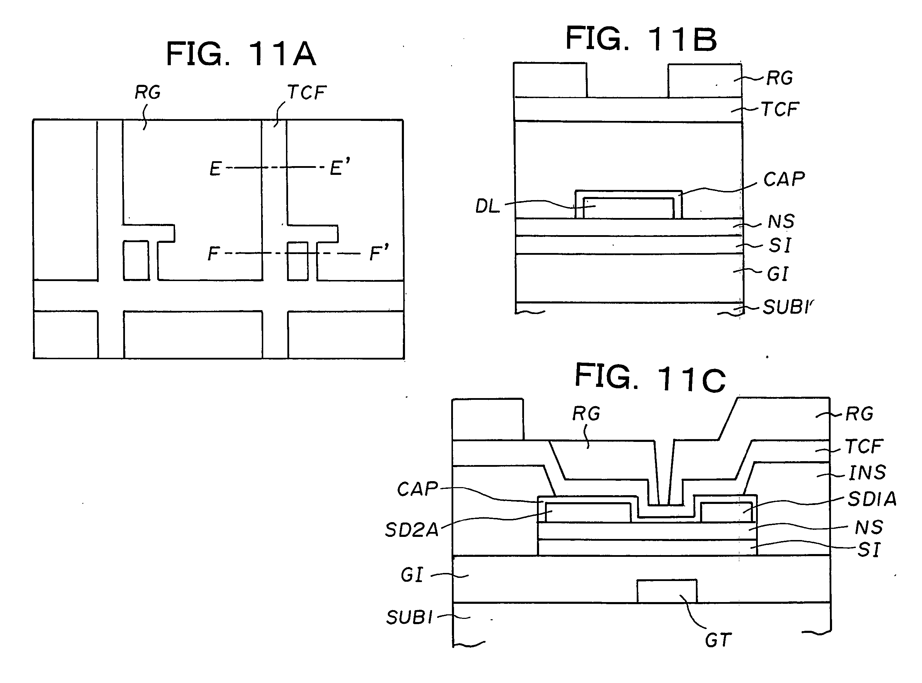

Next, the pixel and gap forming process in Fig. 7 (b) includes the formation of a pixel electrode and a process to separate and fabricate source electrode and drain electrode. First, after the process (P-10) shown in Fig. 7, ITO is sputtered on the front surface (P-11). IZO, IZTO, etc. may be used instead of ITO. The photosensitive resist RG is coated on it as shown in Fig. 11 (a), and photolithographic process is performed in order to expose ITO of the data line, the gate line and the channel region (P-12). In Fig. 11 (b), a cross-section along the line E-E' in Fig. 11 (a) is shown, and a cross-section along the line F-F' in Fig. 11 (a) is shown in Fig. 11 (c).

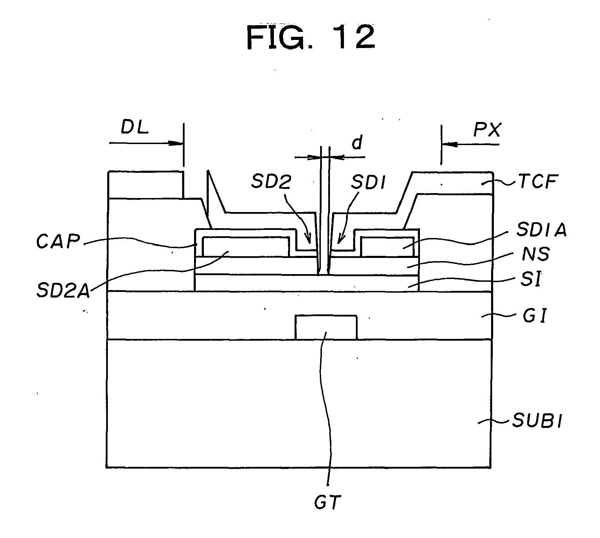

ITO on the exposed portion is etched (P-13), and the cap layer CAP on the channel region is removed. When a nickel film is used as a cap layer on the cap layer, the data line terminal and the gate line terminal, etching is performed on these portions (P-14). As a result, ITO on the channel region is separated to a source electrode SD1 and a drain electrode SD2. In this case, ITO as a pixel electrode is separated in the pixel region. This pixel electrode is integrated with the source electrode SD1. Then, etching is performed on the contact layer NS, and a gap is formed (P-15). By removing the photosensitive resist off, the thin-film transistor is completed. This condition is shown in Fig. 12. In this case, a gap (distance) "d" is a gap of the cap layer CAP, and this is considerably narrower than a gap "D" between the source electrode SD1A and the drain electrode SD2A prepared by the ink jet direct drawing as shown in Fig. 4. For instance, the gap D is 10 µm or more in width while the gap "d" can be set to 4 µm or less in width. This makes it possible to manufacture thin-film transistor at high speed and to have the display with high precision.

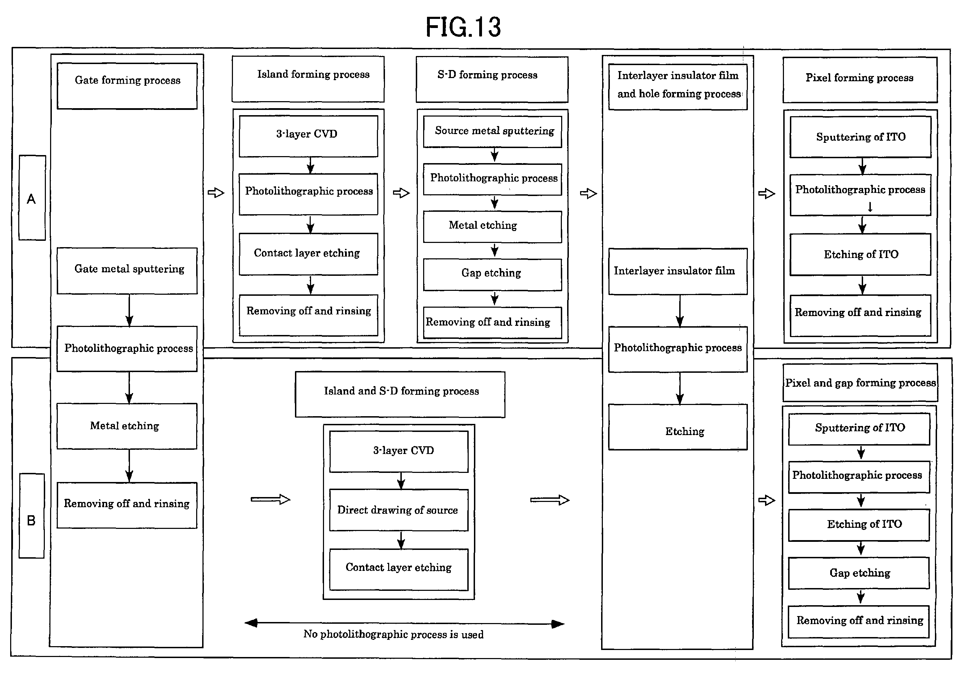

Fig. 13 is a process comparison chart to explain the effects of the present invention. In Fig. 13, a process A to show the prior art and a process B to show the present invention are the same in the gate forming process, the interlayer insulator film and the hole forming process, while these are different in the process for forming the active layer and the source-drain (S-D) and the pixel forming process. In the gate forming process in the process A and the process B, the gate line and the gate electrode are prepared in the order of: gate metal sputtering → photolithographic process → metal etching **→** removing off and rinsing of resist.

In the process A, the process for forming the active layer island and the source-drain (S-D) are performed in the order of: 3-layer CVD → photolithographic process → contact layer etching → removing off and rinsing of resist → sputtering of source metal → photolithographic process → metal etching → gap etching → removing off and rinsing of resist. Also, in the process for forming the interlayer insulator film and the hole, a contact hole is prepared by the processes in the order of: depositing of interlayer insulator film → photolithographic process → etching. In the pixel forming process, the processes are performed in the order of: Sputtering of ITO → photolithographic process → etching → removing off and rinsing of resist.

On the other hand, in the process B of the present invention, the processes for forming the island S-D after the gate forming process as described above are performed in the order of: 3-layer CVD → ink jet direct drawing of the source → etching of contact layer. In the pixel forming process after the interlayer insulator film forming and the hole forming process, the processes are performed in the order of: Sputtering of ITO → photolithographic process → etching → gap etching → removing off and rinsing of resist.

When the process A of the prior art and the process B of the present invention as shown in Fig. 13 are compared with each other, the photolithographic process is not adopted in the process for forming island and S-D in the process B. As a result, the number of light exposure masks can be reduced, and the liquid crystal display system can be manufactured at lower cost.

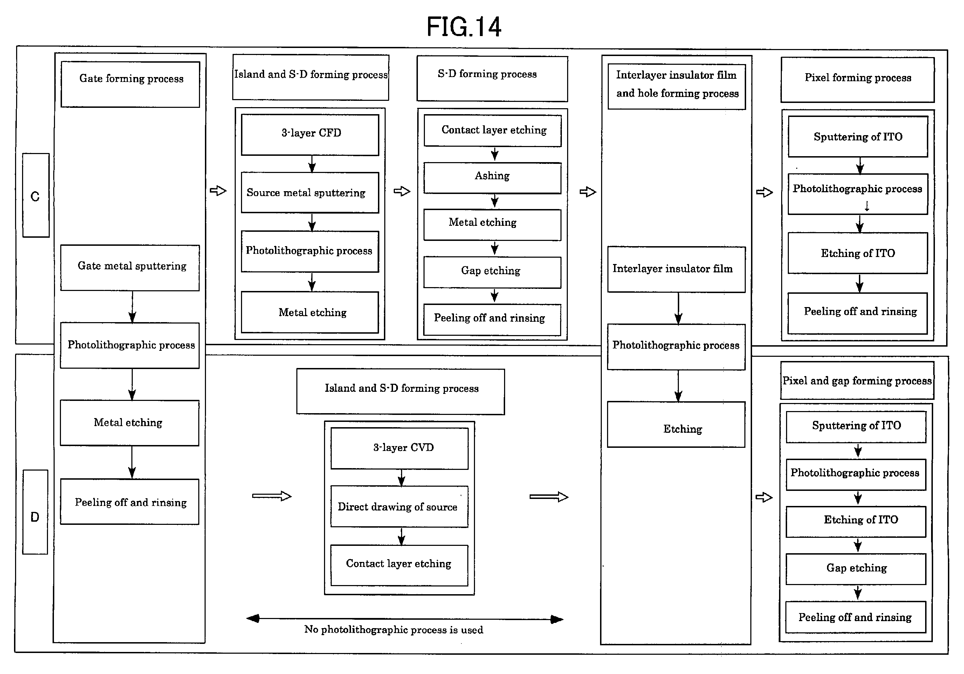

Fig. 14 is another process comparison chart to explain the effects of the present invention. The process C of the prior art and the process B of the present invention are the same in the gate forming process and in the process for forming the interlayer insulator film and hole, while the processes are different from each other in the process for forming the active layer island and the source-drain (S-D) and in the pixel forming process. Similarly to the process shown in Fig. 13, in the gate forming process in the process C and the process B, the gate line and the gate electrode are prepared in the order of: gate metal sputtering → photolithographic process → metal etching → removing off and rinsing of resist.

In the process C, the process for forming the active layer island and source-drain (S-D) are performed in the order of: 3-layer CVD → source metal sputtering → photolithographic process → metal etching → contact layer etching → ashing → metal etching → gap etching → removing off and rinsing of resist. Also, in the process for forming the interlayer insulator film and the hole, the contact hole as required can be prepared in the order of: depositing the interlayer insulator film → photolithographic process → etching. In the pixel forming process, the processes are performed in the order of: Sputtering of ITO → photolithographic process → etching → removing off and rinsing of resist.

On the other hand, in the process B of the present invention, similarly to the case shown in Fig. 13, the process for forming island and S-D is performed in the order of: 3-layer CVD → ink jet direct drawing of source → contact layer etching. In the pixel forming process after the process for forming the interlayer insulator film and hole, the processes are performed in the order of: sputtering of ITO → photolithographic process → etching → gap etching → removing off and rinsing of resist.

When the process C of the prior art and the process B of the present invention as shown in Fig. 14 are compared with each other, the photolithographic process is not adopted in the process for forming island and S-D in the process B. As a result, the number of the light exposure masks can be reduced and the liquid crystal display system can be manufactured at lower cost.

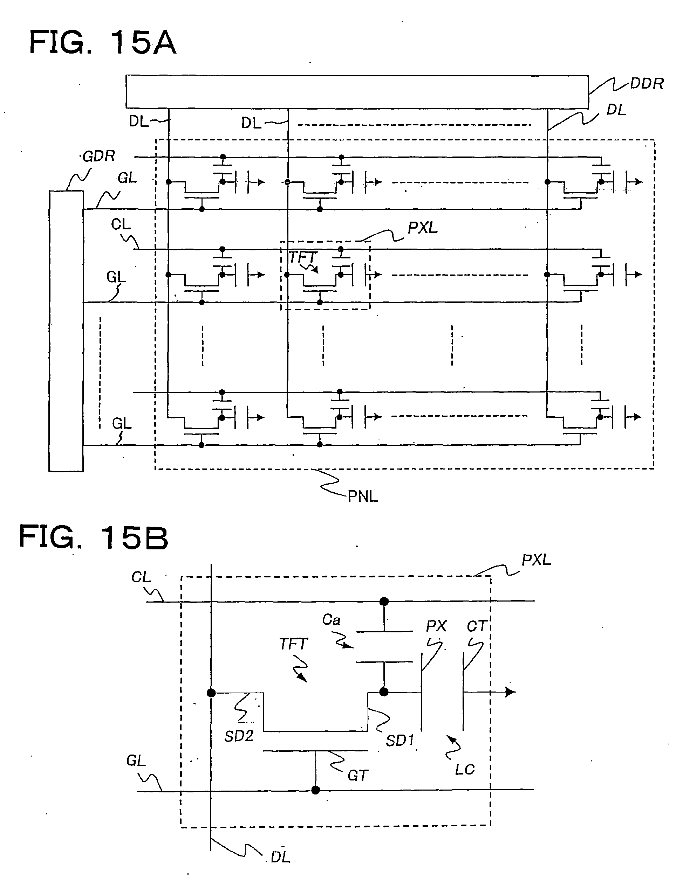

Fig. 15 represents diagrams to explain equivalent circuit of an active matrix type liquid crystal display system. Fig. 15 (a) is a circuit diagram of an entire liquid crystal display panel, and Fig. 15 (b) is an enlarged view of a pixel region PXL shown in Fig. 15 (a). In Fig. 15 (a), a multiple of pixels PXLs are arranged in matrix form on a display panel PNL. Each pixel region PXL is selected by a gate line driving circuit GDR and is turned on according to a display data signal sent from a data line driving circuit DDR.

Specifically, to match the gate line GL selected by the gate line driving circuit GDR, display data (voltage) is supplied to the thin-film transistor TFT on the pixel PXL of the liquid crystal display panel PNL via the data line DL from the data line driving circuit DDR.

As shown in Fig. 15 (b), the thin-film transistor TFT, which makes up the pixel PXL, is disposed at an intersection of the gate line GL and the data line DL. The gate electrode GT of the thin-film transistor TFT is connected to the gate line GL, and the data line DL is connected to the drain electrode SD2 of the thin-film transistor TFT.

The source electrode SD1 of the thin-film transistor TFT is connected to the pixel electrode PX of the liquid crystal (element) LC. The liquid crystal LC is positioned between the pixel electrode PX and the common electrode CT and is driven by a data (voltage) supplied to the pixel electrode PX. An auxiliary capacity Ca to temporarily maintain the data is connected between the drain electrode SD2 and the auxiliary capacity line CL.

In the description as given above, the lines and the electrodes or island forming layers to be formed by direct drawing of ink jet are dried after,the ink is coated by the ink jet method. After baking, the thin-film is prepared.

## Claims

1. A method for manufacturing a liquid crystal display panel, comprising a first substrate where a thin-film transistor is formed for each of a plurality of pixels arranged in matrix form, a second substrate where a color filter is formed, and a liquid crystal sealed into a gap between said first substrate and said second substrate, wherein said method comprises the steps of:
depositing a semiconductive layer on said fist substrate and forming an active layer by depositing a contact layer on an upper layer of said semiconductive layer;
coating a first electroconductive ink to be a source electrode and a drain electrode of said thin-film transistor by ink jet direct drawing and forming a first continuous conductive film including channel region of said thin-film transistor;
coating a second electroconductive ink by ink jet direct drawing on said first conductive film to prepare a cap layer, and forming a laminated film together with said first conductive film; and
forming a source-drain electrode where said source electrode and said drain electrode are continuous to each other by patterning of said laminated layer; and
performing the patterning on said active layer by using said source-drain electrode as an etching mask and forming an active layer island.

2. A method for manufacturing a liquid crystal display panel according to claim 1, wherein said first electroconductive ink contains a low-resistance metal particles dispersed in a solvent, and said second electroconductive ink contains transparent conductive particles or metal particles dispersed in a solvent.

3. A method for manufacturing a liquid crystal display panel according to claim 2, wherein:
said low-resistance metal particles contained in said first electroconductive ink are silver particles or copper particles or mixture of these particles; and
the transparent conductive particles contained in said second electroconductive ink are metal oxide particles, and the metal particles are nickel particles.

4. A method for manufacturing a liquid crystal display panel, comprising a first substrate where a thin-film transistor is formed for each of a plurality of pixels arranged in matrix form, a second substrate where a color filter is formed, and a liquid crystal sealed into a gap between said first substrate and said second substrate, wherein said method comprises the steps of:
depositing a semiconductive layer on said fist substrate and forming an active layer by depositing a contact layer on an upper layer of said semiconductive layer;
coating a first electroconductive ink to be a source electrode and a drain electrode of said thin-film transistor by ink jet direct drawing and forming a first continuous conductive film including channel region of said thin-film transistor;
coating a second electroconductive ink by ink jet direct drawing on said first conductive film to prepare a cap layer, and forming a laminated film together with said first conductive film; and
forming a source-drain electrode, where said source electrode and said drain electrode are continuous to each other, by patterning of said laminated layer; and
performing the patterning on said active layer by using said source-drain electrode as an etching mask and forming an active layer island;
depositing a transparent conductive film to cover the surface of the substrate including the source-drain electrode on said active layer island;
coating a photoresist, exposing said transparent conductive film of said channel region by photolithographic method, and exposing a contact layer on an upper layer by removing said transparent conductive film of the exposed portion by etching; and
forming the channel region on a semiconductor layer on a lower layer through etching of the exposed contact layer.

5. A method for manufacturing a liquid crystal display panel according to claim 4, wherein:
said first electroconductive ink contains low-resistance metal particles dispersed in a solvent; and
said second electroconductive ink contains transparent conductive particles or metal particles dispersed in a solvent.

6. A method for manufacturing a liquid crystal display panel according to claim 4, wherein:
said low-resistance metal particles contained in said first electroconductive ink are silver particles or copper particles or mixture of these particles; and
the transparent conductive particles contained in said second electroconductive ink are metal oxide particles, and the metal particles are nickel particles.

7. A method for manufacturing a liquid crystal display panel according to claim 4, wherein:
said transparent conductive film is made of ITO, IZO or IZTO.

8. A liquid crystal display panel, comprising a first substrate where a thin-film transistor is formed for each of a plurality of pixels arranged in matrix form, a second substrate where a color filter is formed, and a liquid crystal sealed into a gap between said first substrate and said second substrate,
said thin-film transistor, which comprises gate lines, gate electrodes extending from said gate lines, data lines, data electrodes extending from said data lines, pixel electrodes, source electrodes in the same layer as drain electrodes and connected to said pixel electrodes, and an active layer consisting of a semiconductor layer and a contact layer formed on an upper layer of said semiconductor layer,
said drain electrode and said source electrode of the thin-film transistor having said first substrate comprises a laminated film and a transparent conductive film, said laminated film including a first conductive film formed by coating of direct drawing of ink jet with a second conductive film to be a cap layer formed by direct drawing of ink jet being laminated on said first conductive film, and said transparent conductive film being deposited on an upper layer of said laminated film..

9. A liquid crystal display panel according to claim 8, wherein:
said transparent conductive film makes up a pixel electrode integrated with one of said drain electrode or said source electrode in said pixel region.

10. A liquid crystal display panel according to claim 8, wherein:
said transparent conductive film makes up a data line integrated with the other of said drain electrode and said source electrode in said data line region.

11. A liquid crystal display panel according to claim 8, wherein:
said first conductive film is a low-resistance metal thin-film, and
said second conductive film is a transparent conductive film or a metal thin-film.

12. A liquid crystal display panel according to claim 11, wherein:
said low-resistance metal thin-film is a baked film of silver particles or a baked film of copper particles or a baked film of mixture of these particles; and
said transparent conductive film is a baked film of the metal oxide particles or a baked film of the metal particles.

13. A liquid crystal display panel according to claim 12, wherein:
said metal oxide particles are made of ITO, IZO or IZTO, and said metal particles are nickel particles.

14. A liquid crystal display panel according to claim 8, wherein:
a gap between opposed ends of said cap layer of said laminated film to make up said drain electrode and said source electrode is narrower than a gap between opposed ends of said first conductive film of said laminated film.

15. A liquid crystal display panel according to claim 8, wherein:
a gap between opposed ends of said transparent conductive film to make up said source electrode and said drain electrode is narrower than a gap between opposed ends of said first conductive film of said laminated film.

16. A liquid crystal display panel according to claim 8, wherein:
the gate line and the gate electrode to make up said thin-film transistor are formed by coating of ink jet of an electroconductive ink and by baking.

17. A liquid crystal display panel according to claim 8, wherein:
said the data lines to make up said thin-film transistor are formed by coating of ink jet of an electroconductive ink and by baking.
